# FASCICULE DE BREVET EUROPEEN

(11) **EP 1 825 558 B1**
(45) Date de publication et mention de la délivrance du brevet: **29.06.2016**
(21) Numéro de dépôt: 05815909.6
(22) Date de dépôt: 07.12.2005
(51) Int. Cl.: H01P 5/107

(54) **COMPOSANT ELECTRONIQUE MINIATURE POUR APPLICATIONS HYPERFREQUENCES**
ELEKTRONISCHE MINIATURKOMPONENTE FÜR MIKROWELLENANWENDUNGEN
MINIATURE ELECTRONIC COMPONENT FOR MICROWAVE APPLICATIONS

(30) Priorité: 20.12.2004 FR 0413583
(43) Date de publication de la demande: 29.08.2007
(73) Titulaire: United Monolithic Semiconductor S.A.S., 91401 Orsay Cedex (FR)
(72) Inventeur: VAUDESCAL, Olivier, F-78114 MAGNY-LES-HAMEAUX (FR); QUENTIN, Pierre, F-94270 LE KREMLIN BICETRE (FR); CAMIADE, Marc, F-91440 BURES SUR YVETTE (FR)
(74) Mandataire: Lucas, Laurent Jacques
(86) Numéro de dépôt international: PCT/EP2005/056584
(87) Numéro de publication internationale: WO 2006/067046

(56) Documents cités:
- EP-A2- 1 077 502
- WO-A-2004/049496
- WO-A1-2004/023675
- JP-A- H05 273 234
- US-A- 6 040 739
- PATENT ABSTRACTS OF JAPAN vol. 010, no. 035 (E-380), 12 février 1986 (1986-02-12) -& JP 60 192401 A (HITACHI SEISAKUSHO KK; others: 01), 30 septembre 1985 (1985-09-30)
- PATENT ABSTRACTS OF JAPAN vol. 011, no. 204 (E-520), 2 juillet 1987 (1987-07-02) -& JP 62 029203 A (MATSUSHITA ELECTRIC IND CO LTD), 7 février 1987 (1987-02-07)
- GRESHAM I ET AL: "A 76-77GHz pulsed-doppler radar module for autonomous cruise control applications" MICROWAVE SYMPOSIUM DIGEST. 2000 IEEE MTT-S INTERNATIONAL BOSTON, MA, USA 11-16 JUNE 2000, PISCATAWAY, NJ, USA,IEEE, US, vol. 3, 11 juin 2000 (2000-06-11), pages 1551-1554, XP010507151 ISBN: 0-7803-5687-X

## Description

L'invention concerne les composants électroniques fonctionnant à des fréquences millimétriques comportant un accès électromagnétique sans contact.

Ces types de composants électroniques comportant au moins une puce (ou circuit intégré) fonctionnant à des fréquences millimétriques ont des applications notamment dans le domaine de radars pour automobile. Dans ces types d'applications, une onde électromagnétique est émise à une fréquence millimétrique, l'onde réfléchie par un obstacle est reçue par une antenne pour extraire de cette onde des informations de distance, d'une part, et de vitesse relative d'autre part, entre cet obstacle et la source qui a émis l'onde. A cet effet le véhicule est équipé d'un système comportant des radars positionnés tout autour du véhicule permettant la détection d'objets. Des radars longue portée, fonctionnant par exemple à 77GHz sont positionnés à l'avant du véhicule et des radars courte portée, fonctionnant à 24 GHZ et 79 GHz sont positionnées à l'arrière et sur les cotés du véhicule.

Les informations de vitesse relative et distance sont transmises à une unité centrale du système qui assure, par exemple, le maintient du véhicule à une distance déterminé par rapport aux objets ou par rapport à un autre mobile circulant sur la même route.

L'objectif de ces systèmes utilisant des radars pour automobile est d'apporter, dans un premier temps, un confort de conduite avec des fonctions d'asservissement de la vitesse du véhicule par rapport à un autre véhicule le précédent, mais aussi d'assurer un signalement de dangers potentiels.

D'une façon générale ces systèmes utilisant des radars pour automobile comportent des fonctions élémentaires de génération de fréquence, d'émission et de réception d'ondes hyperfréquences.

Les composants fonctionnant à des fréquences millimétriques peuvent également être utilisés pour des applications de communication à courte distance et très haut débit.

Quelle que soit l'application, le traitement électronique des signaux à fréquence millimétrique comprend une partie de traitement à basse fréquence pouvant être mise en oeuvre par des circuits intégrés en silicium montés sur des circuits imprimés. Cette partie peut être réalisée par des technologies très largement répandues et à faible coût, avec des connexions simples à réaliser entre éléments de circuits sur une même puce de circuit intégré ou entre différentes puces de circuit-intégré. Le traitement comprend aussi une partie à très haute fréquence (supérieure à 45 GHz), ne pouvant être mise en oeuvre que par des composants et des circuits intégrés en matériaux semi-conducteurs adaptés aux hyperfréquences (arséniure de gallium GaAs et ses dérivés notamment, ou encore SiGe). Ces circuits intégrés sont appelés MMIC pour "microwave monolithic integrated circuits". Cette partie très haute fréquence pose des problèmes de réalisation difficiles et s'avère en général très coûteuse.

Pour des fonctions relativement complexes, on réalise des composants encapsulés dans un boîtier métallique comportant un nombre important de puces MMIC, la quantité d'éléments de circuit qu'on peut mettre dans une même puce étant beaucoup plus limitée pour les circuits MMIC que pour les circuits basse-fréquence au silicium. Ces puces sont montées sur un substrat comportant des interconnexions difficiles à réaliser et donc coûteuses compte-tenu des fréquences très élevées auxquelles on travaille.

Le montage des puces sur un substrat hybride (montage en général avec câblage filaire pour relier les puces au substrat hybride) est lui-même très coûteux lorsque les puces sont nombreuses.

Ces composants comportent, notamment dans le cas d'applications pour l'automobile, des accès sans contact par couplage électromagnétique pour l'émission et la réception des ondes.

La transmission par couplage électromagnétique à ces très hautes fréquences est assurée en utilisant les propriétés de propagation libre des signaux électromagnétiques à l'intérieur du boîtier et surtout entre l'intérieur et l'extérieur. Ce boîtier comprend notamment un capot conducteur (capot métallique ou métallisé) qui enferme les lignes de propagation des signaux issus de la puce ou allant vers la puce. Le capot conducteur est situé au-dessus de l'accès extérieur sans contact, à une distance telle qu'il constitue (à la fréquence principale de travail pour laquelle le composant est conçu) un court-circuit électromagnétique favorisant la transmission de signal en propagation libre par cet accès.

Les accès à la fréquence de travail F0 de plus de 45 GHz sont des transitions par couplage électromagnétique dans l'air (ou dans un gaz ou dans le vide), et notamment des éléments conducteurs capables de rayonner vers un guide d'onde placé en regard de ces éléments, ou capables de recevoir un rayonnement électromagnétique en sortie d'un guide d'onde devant lequel ils sont placés. Le boîtier dans lequel sont enfermées les puces MMIC comporte une partie non conductrice en regard de ces éléments conducteurs de manière à laisser passer l'énergie électromagnétique entre le guide et les éléments conducteurs.

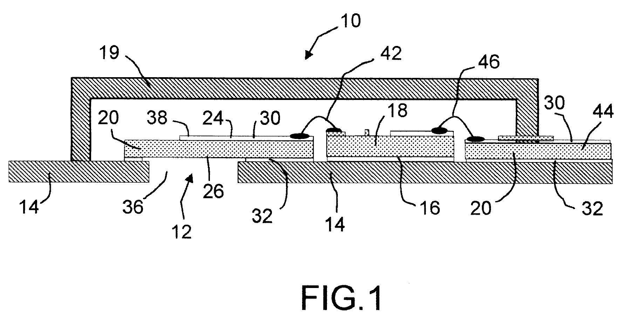

La figure 1 représente un composant de l'état de l'art pour des applications automobile. Le composant est encapsulé dans un boîtier 10 comportant un accès électromagnétique 12 sans contact.

Le composant comporte une embase métallique 14, servant de substrat sur lequel est directement reporté, par sa face arrière 16, une puce hyperfréquence MMIC 18, un substrat céramique double face 20 servant aux interconnexions à l'intérieur du boîtier et vers l'extérieur du boîtier, et un capot métallique ou métallisé19 recouvrant l'embase pour enfermer, entre l'embase et le capot, la puce et le substrat de céramique 20. La puce MMIC 18 est soudée directement sur l'embase 14.

Le substrat céramique 20 est de préférence un substrat métallisé sur ses deux faces 24, 26 comportant des métallisations 30 sur sa face avant 24 pour constituer des lignes de transmission, des métallisations 32 sur sa face arrière 26 pour constituer un plan de masse.

Les dimensions des différentes parties diélectriques et conductrices sont telles que le composant fonctionne correctement à la fréquence de travail considérée F0 (77 GHz). Les métallisations 30 et 32 servent d'une part à établir des interconnexions entre puces et d'autre part à établir les accès extérieurs du boîtier.

L'accès 12 du composant de la figure 1 comprend une transition par couplage électromagnétique sans contact permettant de faire passer le signal à la fréquence de 77GHz sans contact d'un guide d'ondes vers la puce MMIC 18 ou réciproquement.

Cette transition par couplage électromagnétique se fait de préférence par l'intermédiaire d'une ouverture 36 dans le boîtier 10, et plus précisément dans l'embase métallique 14.

Le substrat 20 comporte un élément rayonnant 38 communiquant par exemple avec un guide d'onde placé devant l'ouverture 36, l'élément rayonnant jouant le rôle d'élément de réception et d'émission d'une onde électromagnétique entrante ou sortante dans le boîtier.

Les liaisons électriques entre le substrat 20 et la puce 18 sont réalisées par câblage filaire.

Le composant comporte d'autres accès 44 fonctionnant à des fréquences inférieures à celles de l'accès hyperfréquences. La puce MMIC est également reliée à ces autres accès 44 par un câblage filaire 46.

La connexion du composant avec un autre composant semblable ou avec un composant différent monté sur un circuit imprimé classique est réalisée par les autres accès 44.

Différents documents divulguent des composants hyperfréquences comportant au moins un accès hyperfréquences sans contact notamment :
La demande de brevet WO 2004/049496 A de la société United Monolithic Semiconductors SAS montre un composant pour radar automobile tel que décrit à la figure 1.

Le document JP 60192401 A de la société HITACHI SEISAKUSHO KK montre un autre composant hyperfréquence de l'état de l'art comportant un circuit intégré hyperfréquence recouvert par un boîtier conducteur électrique et ayant deux accès pour la communication de signaux électriques, un accès hyperfréquence sans contact électrique par couplage électromagnétique et un accès par contact électrique.

La demande de brevet Européen EP 10777 502 de la société Boeing Company montre une transition hyperfréquences pour coupler l'énergie se propageant dans un guide électromagnétique à un circuit intégré monolithique hyperfréquences.

Le brevet japonais JP 5273234 montre un substrat comportant un circuit intégré et deux accès sans contact pour effectuer des tests sur wafer hyperfréquences.

Le document US 6040739 A divulgue un amplificateur hyperfréquence comportant deux transitions hyperfréquences guide d'onde microstrip. L'amplificateur comporte une embase métallique, un substrat diélectrique, et un puce hyperfréquences montée sur l'embase métallique à travers un ouverture dans le substrat diélectrique.

Dans l'application pour les radars automobile l'accroissement des fonctionnalités de tels systèmes implique l'utilisation d'un nombre de plus en plus élevé de radars de détection au tour du véhicule ce qui nécessite un plus grand effort de réduction des coûts des fonctions élémentaire du système.

Un des problèmes majeurs pour ces applications à l'automobile est le coût du module millimétrique d'émission/réception. Ce coût résulte des composants utilisés mais aussi de la technologie d'assemblage utilisée pour fabriquer ces modules.

Les solutions existantes ne permettent d'atteindre les objectifs de coût liés du marché. Ces solutions sont limitées pour deux raisons essentielles, le coût de mise en oeuvre (équipement, apprentissage, reproductibilité), le coût de production.

L'invention propose notamment pour réduire les coûts de production des composants hyperfréquences à accès sans contact un composant miniature hyperfréquences comportant :
- une puce hyperfréquence encapsulée dans un boîtier individuel pour montage en surface, la puce ayant une face active comportant des éléments électroniques et des conducteurs électriques de la face active et une face arrière opposée à la face active comportant des conducteurs électriques de la face arrière et parmi ces conducteurs de la face arrière un conducteur électrique formant un plan de masse ;
- une embase métallique de report de la puce dans le boîtier par sa face arrière comportant une ouverture ;
- au moins deux accès pour la communication de signaux électriques entre l'intérieur et l'extérieur du boîtier, un accès hyperfréquence sans contact, par couplage électromagnétique au niveau de l'ouverture de l'embase, assurant la transmission de signaux de couplage à une fréquence de travail F0 un accès sous-harmoniques par contact pour l'entrée dans le circuit intégré d'une fréquence sous-harmonique F0 de la fréquence de travail F0 ;

caractérisé en ce que la puce comporte, parmi ses conducteurs électriques, un conducteur électrique de couplage connecté aux éléments électroniques de la puce, le conducteur de couplage étant placé au niveau de l'accès hyperfréquence sans contact pour assurer la transmission de signaux hyperfréquences par couplage électromagnétique à la fréquence de travail F0.

Un principal objectif du composant hyperfréquence selon l'invention est de réduire le coût de fabrication du composant et de simplifier sa fabrication.

Un deuxième objectif est de pouvoir utiliser une technologie de fabrication du composant très proche des technologies actuellement mises en oeuvre pour des fabrications en volume important, par exemple, celles utilisées pour les composants en boîtier plastique.

Un autre objectif du composant est sa compatibilité avec les techniques de montage en surface, ce qui représente un atout majeur pour des applications à des telles fréquences millimétriques.

Le conducteur électrique de couplage de la puce fait office de capteur électromagnétique couplé avec un guide d'onde formé par l'accès sans contact du boîtier.

Le composant hyperfréquence selon l'invention comporte, de préférence, en plus d'un accès sans contact capable d'un couplage efficace à plus de 45 GHz (au moins jusqu'a 120 GHz), un accès non capable de travailler efficacement à une fréquence supérieure à 45 GHz mais conçu pour travailler à une fréquence sous-harmonique de la fréquence de travail. A cet effet, le circuit intégré comporte de préférence des moyens de multiplication de fréquence nécessaires pour passer de la fréquence sous-harmonique F0/n (n étant un nombre entier) à la fréquence de travail F0.

L'accès incapable de travailler à 77 GHz mais capable de travailler jusqu'à 40 GHz ou un peu plus, est réalisé, sur le circuit intégré, au moyen de lignes micro-ruban (aussi appelées microstrip) ou des lignes coaxiales.

La connexion du circuit intégré avec d'autres composants placés sur un même substrat se fera facilement du fait que les fréquences transportées sont beaucoup plus faibles que la fréquence millimétrique de travail.

Dans une première réalisation du composant hyperfréquence selon l'invention, le boîtier comporte un capot conducteur placé à une distance du conducteur de couplage telle qu'il établisse au-dessus de l'accès hyperfréquences sans contact un court-circuit électromagnétique à la fréquence de travail F0 formant ainsi un réflecteur d'onde favorisant la transmission de cette fréquence de travail F0 à travers l'accès hyperfréquence.

Dans une autre réalisation du composant hyperfréquence, le conducteur électrique de couplage et un plan de masse de la puce forment une antenne à fente favorisant la transmission de la fréquence de travail à travers l'accès hyperfréquence sans contact.

D'autres caractéristiques et avantages de l'invention apparaîtront à la lecture de la description détaillée qui suit et qui est faite en référence aux dessins annexés dans lesquels :
- la figure 1, déjà décrite, représente un composant en boîtier millimétrique de l'état de l'art ;
- les figures 2a et 2b représentent des vues d'une première réalisation du composant hyperfréquences selon l'invention ;
- la figure 2c représente le couplage du composant des figures 2a et 2b avec un guide d'onde ;
- la figure 2d représente une vue de dessus d'un substrat de couplage dans le couplage de la figure 2c ;
- les figure 3a et 3b représentent des vues d'une variante de réalisation du composant hyperfréquences des figures 2a et 2b ;
- la figure 3c représente le couplage du composant des figures 3a et 3b avec un guide d'onde ;
- la figure 3d représente une vue de dessus du substrat de couplage dans le couplage de la figure 3c ;

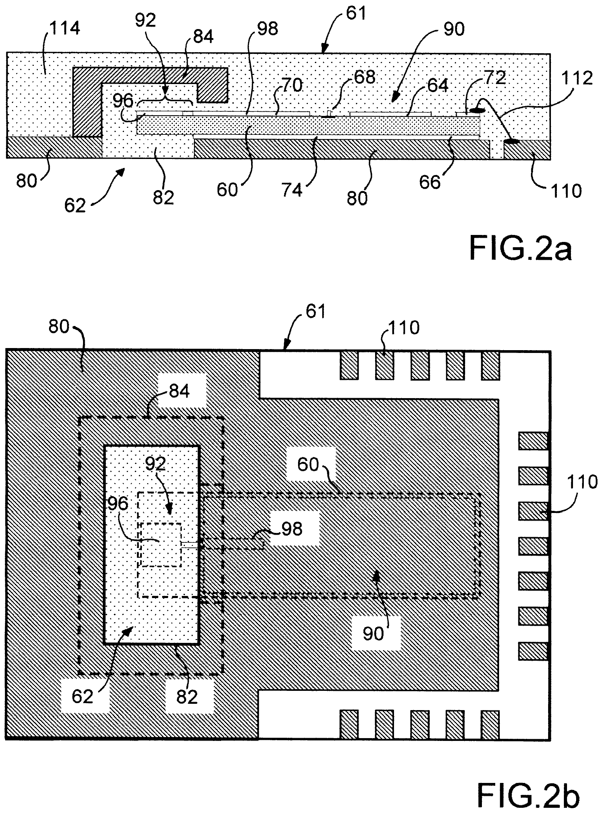

Les figures 2a et 2b, représentent respectivement une vue en coupe et une vue de dessus d'un premier exemple de réalisation d'un composant hyperfréquences selon l'invention.

Le composant des figures 2a et 2b comporte une puce MMIC 60 encapsulée dans un boîtier 61 ayant un accès 62 par couplage électromagnétique.

La puce MMIC 60 comporte une face active 64 et une face arrière 66, opposée à la face active ; les deux faces 64, 66 sont métallisées. La face active 64 comporte des composants électroniques 68 et des conducteurs électriques 70, 72 de la face active. La face arrière 66 comporte des conducteurs électriques de la face arrière et parmi ces conducteurs de la face arrière un conducteur formant un plan de masse 74.

Le boîtier 61 comporte une embase métallique 80 servant de substrat sur laquelle est directement reportée la puce MMIC 60 par sa face arrière 66, l'embase ayant une ouverture 82 pour le passage des ondes électromagnétiques reçues ou émises par le circuit intégré formant avec un capot métallique 84 reporté sur l'embase métallique, l'accès 62 par couplage électromagnétique sans contact.

La puce MMIC 60 comporte, du coté d'une de ses extrémités, une zone de report 90 sur l'embase métallique 80 du boîtier et, du côté d'une autre extrémité opposée à la première, une zone de transition électromagnétique 92 au niveau de l'accès 62 par couplage électromagnétique, par exemple avec un guide d'onde. La face arrière 66 de la puce, au niveau de la zone de transition 92, ne comporte pas de métallisation pour laisser le passage des ondes électromagnétique par l'accès 62 sans contact.

La zone de transition 92 de la puce comporte, de préférence sur la face active 64, un conducteur électrique de couplage 96 relié à une ligne microstrip 98 de la puce formée par un conducteur de la face active et le plan de masse 74 de la face arrière.

L'accès électromagnétique 62 du boîtier assure une transition sans contact des signaux hyperfréquences entre le composant et un guide d'onde couplé au composant.

L'accès 62 sans contact est réalisé, dans cet exemple des figures 2a et 2b, par le capot métallique 84 et l'ouverture 82 dans l'embase métallique formant un guide d'onde à la fréquence de travail F0 d'émission/réception du circuit intégré 60.

Les dimensions des différentes parties diélectriques et conductrices du boîtier sont telles que le composant fonctionne correctement à la fréquence de travail F0 considérée (77 GHz).

Le boîtier comporte, du côté de l'embase métallique 80, en plus du conducteur électrique de masse 82, des plots électriques 110 pour l'interconnexion du circuit intégré avec d'autres composants électroniques par l'intermédiaire d'un substrat d'interconnexion.

Les conducteurs électriques 72 de la face active de la puce, pour d'autres d'accès à la puce, sont reliés par des fils de connexion 112 aux plots électriques du boîtier. Ces autres accès par contact sont destinés à transmettre vers la puce : la fréquence sous-harmonique de la fréquence de travail F0 (77 GHz), des signaux de contrôle, les alimentations.

Le boîtier est fermé par un moulage 114 en matériau diélectrique recouvrant la surface active du circuit intégré et laissant apparaître la surface de report du boîtier comportant les plots électriques de report.

De préférence, le matériau diélectrique rempli l'accès électromagnétique 62 sans contact du boîtier, mais dans d'autres réalisations, l'espace entre le capot et l'embase métallique peuvent contenir un gaz environnant le composant, par exemple de l'air.

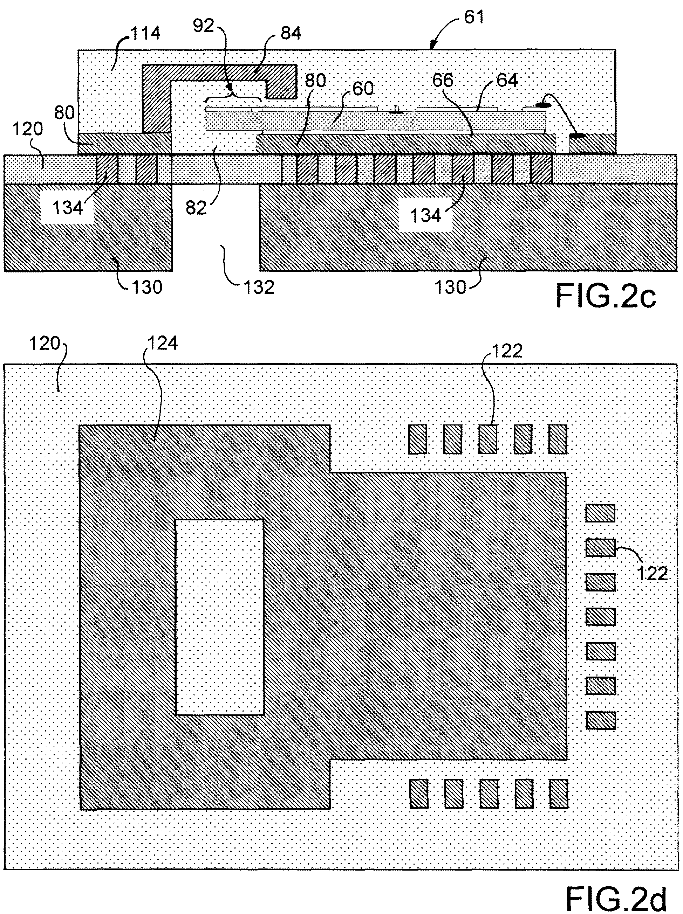

La figure 2c représente le couplage du composant des figures 2a et 2b avec un guide d'onde.

Le boîtier 61 est reporté sur un substrat de couplage120 comportant, du côté de sa face de report du boîtier, des conducteurs électriques 122 pour l'interconnexion avec les plots électriques 110 du boîtier et un plan de masse 124. La figure 2d représente une vue du substrat de couplage du composant des figures 2a et 2b avec le guide d'onde.

Le substrat de couplage 120 est reporté par son autre face sur un guide d'onde 130 sous forme de plaque métallique comportant une ouverture 132 faisant face à l'ouverture 82 de l'embase 80 du circuit intégré et de même forme.

Des transitions métalliques 134 entre les deux faces du substrat 120 assurent un contact électrique et thermique entre l'embase métallique du boîtier 61 le guide d'onde 130.

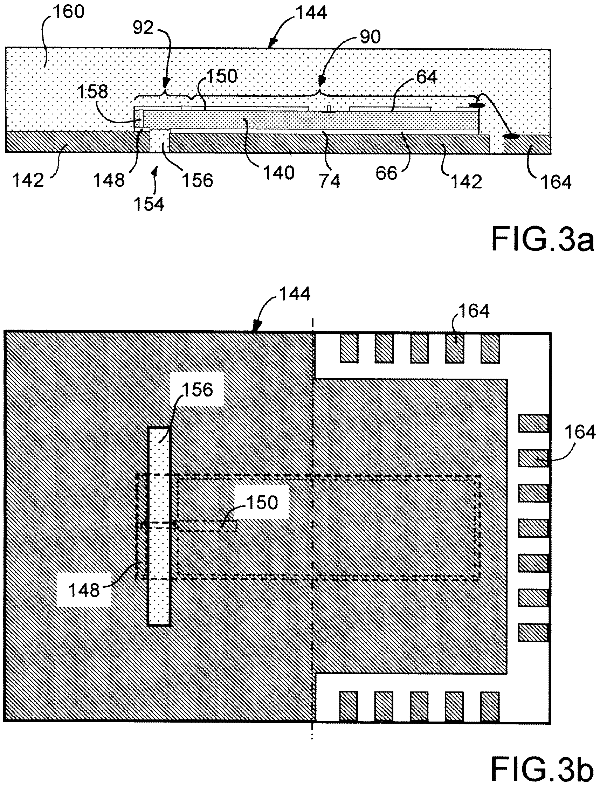

Les figure 3a et 3b représentent des vues d'une variante de réalisation du composant des figures 2a et 2b selon l'invention.

Dans cette variante, une puce MMIC 140, reportée sur une embase métallique 142 d'un boîtier d'encapsulation 144 comporte, dans la zone de transition 92, du coté de la face arrière 66 de la puce, un conducteur électrique d'antenne 148 relié électriquement à une ligne microstrip 150 de la puce formée par un conducteur de la face active et le plan de masse de la face arrière 66 au niveau de la zone de report 90 de la puce. Le conducteur électrique d'antenne 148 forme avec le plan de masse 74 de la zone de report 90 de la puce une antenne à fente à la fréquence de travail F0 d'émission/réception du circuit intégré.

L'accès 154 par couplage électromagnétique, dans le composant des figures 3a et 3b, est réalisée par une ouverture 156 sous forme de fente dans l'embase métallique 142 faisant face à l'antenne à fente de la puce dans la zone de transition 92. L'ouverture 156 de l'embase, sous forme de fente, forme une ligne à fente pour le couplage du composant avec un guide d'onde.

La liaison électrique entre le conducteur électrique d'antenne 148 de la face arrière de la puce et le conducteur électrique de la face active de la ligne microstrip est réalisée par un trou métallisé 158.

Le boîtier 144 est fermé par un moulage 160 en matériau diélectrique recouvrant la face active de la puce mais laissant libre la surface de report du boîtier. De préférence, le matériau diélectrique rempli la fente métallique 156 de l'embase 142 dirigeant le champ électromagnétique vers l'accès 154 sans contact.

Le boîtier 144 comporte, du côté de l'embase métallique, en plus du conducteur électrique de masse 74, des plots électriques 164 pour la connexion électrique de la puce avec d'autres accès du circuit intégré, alimentation signaux de commande etc.

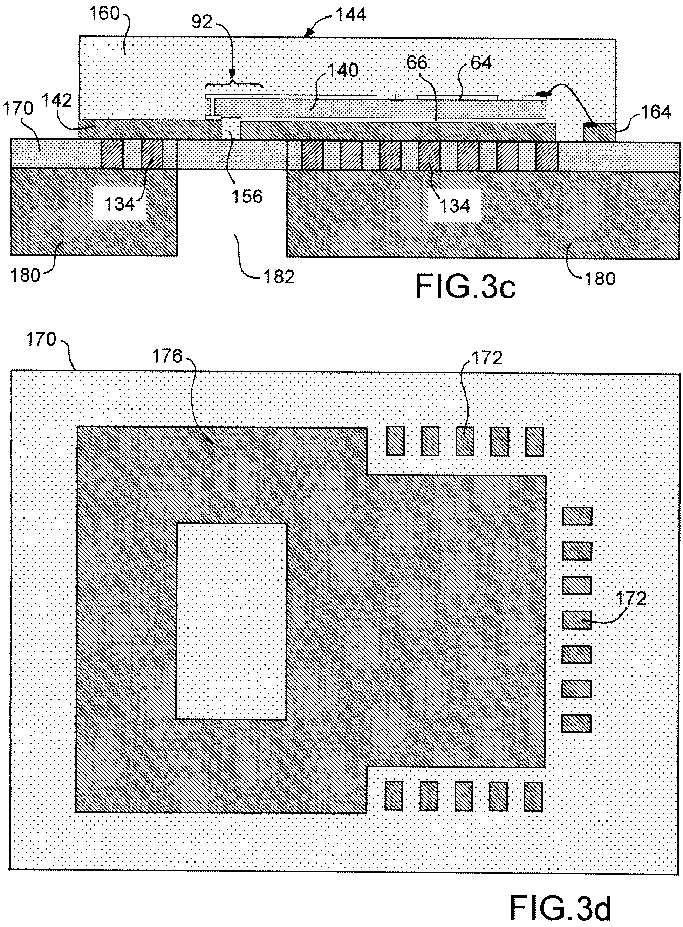

La figure 3c représente le couplage du composant des figures 3a et 3b avec un guide d'onde.

Le boîtier 144 est reporté sur un substrat de couplage 170 comportant sur la face de report du boîtier des conducteurs électriques 172 pour l'interconnexion avec les plots électriques 164 du boîtier 144 et un plan de masse 176. La figure 3d représente une vue du substrat de couplage 170 du coté de la face de report du composant sur le substrat de couplage.

Le substrat de couplage est reporté par son autre face sur une des faces d'un guide d'onde 180 sous forme de plaque métallique comportant une ouverture rectangulaire182 faisan face à l'ouverture 156 de l'embase 142. L'ouverture rectangulaire du guide d'onde 180 peut être de dimensions plus grandes que celles de l'ouverture 156 de l'embase du boîtier, cette ouverture 182 du guide d'onde 180 peut être aussi de dimensions identiques à l'ouverture de l'embase en forme de fente.

Dans d'autres réalisations du composant selon l'invention, la ligne hyperfréquence (98, 150) reliant le conducteur de couplage (ou d'antenne) dans la zone de transition 92 de la puce est une ligne de type coplanaire, dans ce cas, deux conducteurs électriques de la face active de la puce, écartés d'une certaine distance, forment la ligne hyperfréquence.

Parmi les principaux avantage du composant hyperfréquence selon l'invention on peut citer :
- la suppression des connexions de type filaire à la fréquence millimétrique de travail F0 ;
- utilisation des technologies de fabrication des boîtiers hyperfréquences mises en oeuvre pour des applications de production en grandes quantités ;
- le circuit intégré est compatible avec les techniques de montage en surface (CMS).

Ces principaux avantages composant hyperfréquence selon l'invention aboutissent à une réduction notable du coût de fabrication et une reproductibilité des performances.

## Revendications

1. Composant miniature hyperfréquences pour montage en surface sur un substrat d'interconnexion, comportant :
a) une puce hyperfréquences MMIC (18, 60, 140) ayant une face active (24, 64) comportant des composants électroniques (68) et des conducteurs électriques (70, 72) de la face active (64) et une face arrière (66) opposée à la face active comportant des conducteurs électriques de la face arrière et parmi ces conducteurs de la face arrière un conducteur électrique (74) formant un plan de masse,
b) un boîtier (61,144) pour l'encapsulation de la puce hyperfréquences MMIC (18, 60, 140), le boîtier comportant,
- une embase métallique (14, 80, 142) servant de substrat sur laquelle est directement reportée la puce MMIC par sa face arrière ayant deux faces opposées, une face de report de la puce hyperfréquence, sur un plan de masse de l'embase métallique, une face opposée à la face de report de la puce pour le montage en surface du boîtier (61,144) sur le substrat d'interconnexion, une ouverture (36, 82, 156) entre les deux faces opposées de l'embase métallique pour permettre le passage d'une onde électromagnétique,
- au moins deux accès par l'embase métallique (14, 80, 142) pour la communication de signaux électriques entre l'intérieur et l'extérieur du boîtier, un accès hyperfréquences (12, 62, 154) sans contact par couplage électromagnétique au niveau de l'ouverture de l'embase métallique, assurant la transmission de signaux de couplage à une fréquence de travail F0 avec la puce hyperfréquences, un accès sous-harmoniques (110, 164) par contact électrique pour l'entrée dans la puce hyperfréquence d'une fréquence sous-harmonique FO/n de la fréquence de travail F0, n étant un nombre entier supérieur à 1,
- la puce hyperfréquences (60, 140) comportant, parmi ses conducteurs électriques, un conducteur électrique de couplage (96, 148) connecté aux composants électroniques (68) de la puce, le conducteur électrique de couplage étant placé au niveau de l'accès hyperfréquence (62, 154) sans contact pour assurer la transmission de signaux hyperfréquences par couplage électromagnétique à la fréquence de travail F0 entre l'extérieur du boîtier et la puce hyperfréquences,
**caractérisé en ce que** la face de l'embase métallique (80, 142) opposée à la face de report de la puce comporte, outre le plan de masse de l'embase métallique, des plots électriques (110, 122) reliées directement par des fils de connexion (112) aux conducteurs électriques (72) de la face active (64) de la puce (60, 140) pour l'accès dans la puce, de signaux de contrôle, d'alimentations électriques, de la fréquence sous-harmonique F0/n de la fréquence de travail F0.

2. Composant selon la revendication 1, **caractérisé en ce que** la puce hyperfréquences MMIC (60, 140) comporte, du coté d'une de ses extrémités, une zone de report (90) sur l'embase métallique (80) du boîtier et, du côté d'une autre extrémité opposée à la première, une zone de transition électromagnétique (92) au niveau de l'accès (62, 154) par couplage électromagnétique

3. Composant selon l'une des revendications 1 ou 2, **caractérisé en ce que** le boîtier comporte un capot conducteur (84) placé à une distance du conducteur électrique de couplage (96) telle qu'il établisse au-dessus de l'accès (62) hyperfréquences sans contact un court-circuit électromagnétique à la fréquence de travail F0 formant ainsi un réflecteur d'onde favorisant la transmission de cette fréquence de travail F0 à travers l'accès hyperfréquence.

4. Composant selon l'une des revendications 1 à 3, **caractérisé en ce que** la face arrière (66) de la puce, au niveau de la zone de transition (92), ne comporte pas de métallisation pour laisser le passage des ondes électromagnétique par l'accès hyperfréquences (62) sans contact, et **en ce que** la zone de transition (92) de la puce comporte, de préférence sur sa face active (64), le conducteur électrique de couplage (96) relié à une ligne microstrip (98) de la puce formée par un conducteur de la face active et le plan de masse (74) de la face arrière.

5. Composant selon l'une des revendications 1 à 4, **caractérisé en ce que** le boîtier (61, 144) est fermé par un moulage (114, 160) en matériau diélectrique recouvrant la face active (64) de la puce hyperfréquence MMIC (60, 140).

6. Composant selon la revendication 1 à 5, **caractérisé en ce que** le matériau diélectrique rempli l'accès électromagnétique (62) sans contact du boîtier.

7. Composant selon l'une des revendications 1 à 5, **caractérisé en ce que** l'espace entre le capot (84) et l'embase métallique (80) peuvent contenir un gaz environnant le composant, par exemple de l'air.

8. Composant selon l'une des revendications 1 ou 2, **caractérisé en ce que** le conducteur de couplage (148) et un plan de masse (74) de la puce (140) forment une antenne à fente favorisant la transmission de la fréquence de travail à travers l'accès hyperfréquence sans contact (154).

9. Composant selon la revendication 8, **caractérisé en ce que** la puce hyperfréquence MMIC (140) comporte, dans la zone de transition (92), du coté de la face arrière (66) de la puce, un conducteur électrique d'antenne (148) relié électriquement à une ligne microstrip (150) de la puce formée par un conducteur de la face active et le plan de masse de la face arrière (66) au niveau de la zone de report (90) de la puce, le conducteur électrique d'antenne (148) formant, avec le plan de masse (74) de la zone de report (90) de la puce, une antenne à fente à la fréquence de travail F0 d'émission/réception du circuit intégré.

10. Composant selon la revendication 8, **caractérisé en ce que** l'accès hyperfréquence sans contact (154) par couplage électromagnétique est réalisé par une ouverture (156) sous forme de fente dans l'embase métallique (142) faisant face à l'antenne à fente de la puce hyperfréquences dans la zone de transition (92), la liaison électrique entre le conducteur électrique d'antenne (148) de la face arrière de la puce et le conducteur électrique de la face active de la ligne microstrip étant réalisée par un trou métallisé (158).

11. Composant selon la revendication 10, **caractérisé en ce que** le boîtier étant fermé par le moulage (160) en matériau diélectrique recouvrant la face active de la puce mais laissant libre la surface de report du boîtier (144), le matériau diélectrique remplissant la fente métallique (156) de l'embase (142) dirigeant le champ magnétique vers l'accès (154) sans contact.

12. Composant selon l'une des revendications 1 à 11, **caractérisé en ce que** la puce hyperfréquence (60, 140) comporte des moyens de multiplication de fréquence nécessaires pour passer de la fréquence sous-harmonique F0/n à la fréquence de travail F0.

13. Composant selon l'une des revendications 1 à 3, **caractérisé en ce qu'**une ligne hyperfréquence (150) reliant le conducteur de couplage (ou d'antenne) dans la zone de transition (92) de la puce est une ligne de type coplanaire, dans ce cas, deux conducteurs électriques de la face active de la puce, écartés d'une certaine distance, forment la ligne hyperfréquence.

## Patentansprüche

1. Miniatur-Mikrowellenelement zur Oberflächenmontage auf einem Verbindungssubstrat, umfassend:
a) einen Mikrowellenchip MMIC (18, 60, 140) mit einer aktiven Seite (24, 64), umfassend elektronische Komponenten (68) und elektrische Leiter (70, 72) der aktiven Seite (64) und einer Rückseite (66) gegenüber der aktiven Fläche umfassend elektrische Leiter der Rückseite und zwischen diesen Leitern der Rückseite einen elektrischen Leiter (74), der eine Erdungsebene bildet,
b) ein Gehäuse (61,144) für die Verkapselung des Mikrowellenchips MMIC (18, 60, 140), wobei das Gehäuse Folgendes umfasst:
- einen Metallsockel (14, 80, 142), der als Substrat dient, auf den der Mikrowellenchip MMIC direkt durch seine Rückseite mit zwei gegenüberliegenden Flächen aufgesetzt wird, eine Übertragungsfläche des Mikrowellenchips, auf einer Erdungsebene des Metallsockels, eine Fläche gegenüber der Übertragungsfläche des Chips zur Oberflächenmontage des Gehäuses (61,144) auf dem Verbindungssubstrat, eine Öffnung (36, 82,156) zwischen den beiden gegenüberliegenden Flächen des Metallsockels, um den Durchgang einer elektromagnetischen Welle zu ermöglichen,
- mindestens zwei Zugänge durch den Metallsockel (14, 80, 142) zur Kommunikation von elektrischen Signalen zwischen der Innenseite und der Außenseite des Gehäuses, einen kontaktlosen Mikrowellenzugang (12, 62, 154) durch elektromagnetische Kopplung an der Öffnung des Metallsockels, der die Übertragung von Kopplungssignalen bei einer Arbeitsfrequenz F0 mit dem Mikrowellenchip sicherstellt, einen subharmonischen Zugang (110, 164) durch elektrischen Kontakt zum Eintritt einer subharmonischen Frequenz F0/n der Arbeitsfrequenz F0 in den Mikrowellenchip, wobei n eine ganze Zahl größer als 1 ist,
- den Mikrowellenchip (60, 140), umfassend, zwischen seinen elektrischen Leitern einen elektrischen Kopplungsleiter (96, 148), der mit den elektronischen Komponenten (68) des Chips verbunden ist, wobei der elektrische Kopplungsleiter am kontaktlosen Mikrowellenzugang (62, 154) zur Übertragung von Mikrowellensignalen durch elektromagnetische Kopplung bei der Arbeitsfrequenz F0 zwischen der Außenseite des Gehäuses und dem Mikrowellenchip angeordnet ist,
**dadurch gekennzeichnet, dass** die Fläche des Metallsockels (80, 142) gegenüber der Transferfläche des Chips, zusätzlich zu der Erdungsebene des Metallsockels, elektrische Kontakte (110, 122) umfasst, die durch Verbindungsdrähte (112) mit den elektrischen Leitern (72) der aktiven Fläche (64) des Chips (60, 140) für einen Zutritt von Steuersignalen, elektrischen Stromversorgungen, der subharmonischen Frequenz F0/n der Arbeitsfrequenz F0 in den Chip direkt verbunden sind.

2. Komponente nach Anspruch 1, **dadurch gekennzeichnet, dass** der Mikrowellenchip MMIC (60, 140), von der Seite einer seiner Extremitäten, eine Transferzone (90) auf dem Metallsockel (80) des Gehäuses und, von der Seite der anderen Außenfläche her, entgegengesetzt zu der ersten, eine elektromagnetische Übergangszone (92) am Zugang (62, 154) durch elektromagnetische Kopplung umfasst.

3. Komponente nach einem der Ansprüche 1 oder 2, **dadurch gekennzeichnet, dass** das Gehäuse eine leitfähige Abdeckung (84) umfasst, die in einem solchen Abstand von dem elektrischen Kopplungsleiter (96) angebracht ist, dass er über dem kontaktlosen Mikrowellenzugang (62) einen elektromagnetischen Kurzschluss bei der Arbeitsfrequenz F0 einrichten, wodurch ein Wellenreflektor gebildet wird, der die Übertragung dieser Arbeitsfrequenz F0 über den Mikrowellenzugang begünstigt.

4. Komponente nach einem der Ansprüche 1 bis 3, **dadurch gekennzeichnet, dass** die Rückseite (66) des Chips in der Übergangszone (92) keine Metallisierung umfasst, um den Durchtritt von elektromagnetischen Wellen durch den kontaktlosen Mikrowellenzugang (62) zu ermöglichen, und dass die Übergangszone (92) des Chips, vorzugsweise auf seiner aktiven Seite (64), den elektrischen Kopplungsleiter (96) umfasst, der mit einer Mikrostripleitung (98) des Chips, die durch einen Leiter der aktiven Seite und die Erdungsplatte (74) der Rückseite gebildet wird, verbunden ist.

5. Komponente nach einem der Ansprüche 1 bis 4, **dadurch gekennzeichnet, dass** das Gehäuse (61, 144) durch eine Form (114, 160) aus dielektrischem Material geschlossen wird, die die aktive Seite (64) des Mikrowellenchips MMIC (60, 140) abdeckt.

6. Komponente nach Anspruch 1 bis 5, **dadurch gekennzeichnet, dass** das dielektrische Material den kontaktlosen elektromagnetischen Zugang (62) des Gehäuses ausfüllt.

7. Komponente nach einem der Ansprüche 1 bis 5, **dadurch gekennzeichnet, dass** der Raum zwischen der Abdeckung (84) und dem Metallsockel (80) ein Gas enthalten kann, das die Komponente umhüllt, beispielsweise Luft.

8. Komponente nach einem der Ansprüche 1 oder 2, **dadurch gekennzeichnet, dass** der Kopplungsleiter (148) und eine Erdungsebene (74) des Chips (140) eine Schlitzantenne bilden, die die Übertragung der Arbeitsfrequenz durch den kontaktlosen Mikrowellenzugang (154) begünstigt.

9. Komponente nach Anspruch 8, **dadurch gekennzeichnet, dass** der Mikrowellenchip MMIC (140) in der Übergangszone (92) von der Rückseite (66) des Chips aus eine elektrische Leiterantenne (148) umfasst, die elektrisch mit einer Mikrostripleitung (150) des Chips, die durch einen Leiter der aktiven Seite und die Erdungsebene der Rückseite (66) an der Transferzone (90) des Chips ausgebildet ist, verbunden ist, wobei der elektrische Antennenleiter (148) mit der Erdungsebene (74) der Transferzone (90) des Chips eine Schlitzantenne bei der Ausstrahlungs-/Empfangsfrequenz F0 der integrierten Schaltung bildet.

10. Komponente nach Anspruch 8, **dadurch gekennzeichnet, dass** der kontaktlose Mikrowellenzugang (154) durch elektromagnetische Kopplung durch eine Öffnung (156) als Schlitz in dem Metallsockel (142) der Schlitzantenne des Mikrowellenchips in der Übergangszone (92) zugewandt hergestellt wird, wobei die elektrische Verbindung zwischen dem elektrischen Antennenleiter (148) der Rückseite des Chips und dem elektrischen Leiter der aktiven Seite der Mikrostripleitung durch ein metallisches Loch (158) realisiert ist.

11. Komponente nach Anspruch 10, **dadurch gekennzeichnet, dass** das Gehäuse durch die Form (160) aus dielektrischem Material geschlossen wird, die die aktive Seite des Chips abdeckt, jedoch die Transferfläche des Gehäuses (144) freilässt, wobei das dielektrische Material den Metallschlitz (156) des Sockels (142) ausfüllt, und das Magnetfeld in Richtung des kontaktlosen Zugangs (154) geleitet wird.

12. Komponente nach einem der Ansprüche 1 bis 11, **dadurch gekennzeichnet, dass** der Mikrowellenchip (60, 140) Frequenzmultiplikationsmittel umfasst, die zum Passierenlassen der subharmonischen Frequenz F0/n zur Arbeitsfrequenz F0 notwendig sind.

13. Komponente nach einem der Ansprüche 1 bis 3, **dadurch gekennzeichnet, dass** eine Mikrowellenleitung (150), die den Kopplungsleiter (oder den Antennenleiter) im Übergangsbereich (92) des Chips verbindet, eine Leitung des koplanaren Typs ist, in diesem Fall bilden zwei elektrische Leiter der aktiven Seite des Chips, die mit einem bestimmten Abstand beabstandet sind, die Mikrowellenleitung.

## Claims

1. Miniature microwave component for surface mounting onto an interconnection substrate comprising:
a) an MMIC microwave chip (18, 60, 140) having an active face (24, 64) comprising electronic components (68) and electrical conductors (70, 72) of the active face (64) and a rear face (66) opposite the active face comprising electrical conductors of the rear face and, among conductors of the rear face, an electrical conductor (74) forming a ground plane;
b) a package (61, 144) for encapsulating the MMIC microwave chip (18, 60, 140), the package comprising:
- a metallic base (14, 80, 142) serving as a substrate, onto which the MMIC microwave chip is transferred directly by means of its rear face having two opposite faces, a face for transferring the microwave chip on a ground plane of the metallic base, a face opposite the transfer face of chip for surface mounting the package (61, 144) onto the interconnection substrate, an opening (36, 82, 156) between the two opposite faces of the metallic base to allow the passage of an electromagnetic wave;
- at least two accesses through the metallic base (14, 80, 142) for transferring electrical signals between the inside and the outside of the package, a contactless microwave access (12, 62, 154) via electromagnetic coupling in the vicinity of the opening of the metallic base, ensuring the transmission of coupling signals at a working frequency F0 with the microwave chip, a sub-harmonic access (110, 164) via electrical contact for inputting a sub-harmonic frequency F0/n of the working frequency F0 into the microwave chip, with n being an integer greater than 1;
- the microwave chip (60, 140) comprising, among its electrical conductors, an electrical coupling conductor (96, 148) connected to the electronic components (68) of the chip, the electrical coupling conductor being placed at the contactless microwave access (62, 154) to ensure the transmission of microwave signals via electromagnetic coupling at the working frequency F0 between the outside of the package and the microwave chip,
**characterised in that** the face of the metallic base (80, 142) opposite the transfer face of the chip comprises, in addition to the ground plane of the metallic base, electrical pads (110, 122) directly connected by connection wires (112) to the electrical conductors (72) of the active face (64) of the chip (60, 140) for accessing, in the chip, control signals, power supplies and the sub-harmonic frequency F0/n of the working frequency F0.

2. Component according to claim 1, **characterised in that** the MMIC microwave chip (60, 140) comprises, at one of its ends, a transfer zone (90) on the metallic base (80) of the package and, at another end opposite the first end, an electromagnetic transition zone (92) in the vicinity of the access (62, 154) via electromagnetic coupling.

3. Component according to any one of claims 1 to 2, **characterised in that** the package comprises a conducting cap (84) located at a distance from the electrical coupling conductor (96) such that it establishes an electromagnetic short-circuit at the working frequency F0 above the contactless microwave access (62), thus forming a wave reflector promoting the transmission of the working frequency F0 through the microwave access.

4. Component according to any one of claims 1 to 3, **characterised in that** the rear face (66) of the chip, in the vicinity of the transition zone (92), does not comprise any metallisation so as to allow the passage of electromagnetic waves through the contactless microwave access (62), and **in that** the transition zone (92) of the chip comprises, preferably on its active face (64), the electrical coupling conductor (96) connected to a microstrip line (98) of the chip formed by a conductor of the active face and the ground plane (74) of the rear face.

5. Component according to any one of claims 1 to 4, **characterised in that** the package (61, 144) is sealed by a moulding (114, 160) made of dielectric material covering the active face (64) of the MMIC microwave chip (60, 140).

6. Component according to claim 1 to 5, **characterised in that** the dielectric material fills the contactless electromagnetic access (62) of the package.

7. Component according to any one of claims 1 to 5, **characterised in that** the space between the cap (84) and the metallic base (80) can contain a gas surrounding the component, for example air.

8. Component according to any one of claims 1 to 2, **characterised in that** the coupling conductor (148) and a ground plane (74) of the chip (140) form a slot antenna promoting the transmission of the working frequency through the contactless microwave access (154).

9. Component according to claim 8, **characterised in that** the MMIC microwave chip (140) comprises, in the transition zone (92), at the rear face (66) of the chip, an electrical antenna conductor (148) electrically connected to a microstrip line (150) of the chip formed by a conductor of the active face and the ground plane of the rear face (66) in the vicinity of the transfer zone (90) of the chip, the electrical antenna conductor (148) forming, with the ground plane (74) of the transfer zone (90) of the chip, a slot antenna at the transmission/reception working frequency F0 of the integrated circuit.

10. Component according to claim 8, **characterised in that** the contactless microwave access (154) via electromagnetic coupling is realised by an opening (156) in the form of a slot in the metallic base (142) facing the slot antenna of the microwave chip in the transition zone (92), the electrical connection between the electrical antenna conductor (148) of the rear face of the chip and the electrical conductor of the active face of the microstrip line being realised by a metallised hole (158).

11. Component according to claim 10, **characterised in that** the package is sealed by the moulding (160) made of dielectric material covering the active face of the chip but leaving the transfer surface of the package (144) free, with the dielectric material filling the metallic slot (156) of the base (142) directing the magnetic field towards the contactless access (154).

12. Component according to any one of claims 1 to 11, **characterised in that** the microwave chip (60, 140) comprises frequency multiplication means required to switch the sub-harmonic frequency F0/n to the working frequency F0.

13. Component according to any one of claims 1 to 3, **characterised in that** a microwave line (150) connecting the coupling (or antenna) conductor in the transition zone (92) of the chip is a line of the coplanar type, in this case, two electrical conductors of the active face of the chip, separated by a certain distance, form the microwave line.
